# EUROPEAN PATENT SPECIFICATION

(11) **EP 2 827 382 B1**
(45) Date of publication and mention of the grant of the patent: **17.04.2019**
(21) Application number: 13797166.9
(22) Date of filing: 24.04.2013
(51) Int. Cl.: H01L 31/052, H01L 31/04, H01L 31/042, H01L 31/076, H01L 31/0687, H01L 31/024, H01L 31/048, H01L 31/05, H02S 40/22, H01L 31/054

(54) **SOLAR CELL AND METHOD FOR MANUFACTURING SAME**
SOLARZELLE UND VERFAHREN ZUR HERSTELLUNG DAVON
CELLULE SOLAIRE ET SON PROCÉDÉ DE FABRICATION

(30) Priority: 28.05.2012 JP 2012121000
(43) Date of publication of application: 21.01.2015
(73) Proprietor: Panasonic Intellectual Property Management Co., Ltd., Osaka-shi, Osaka 540-6207 (JP)
(72) Inventor: NOBORI, Kazuhiro, Osaka 540-6207 (JP)
(74) Representative: SSM Sandmair
(86) International application number: PCT/JP2013/002784
(87) International publication number: WO 2013/179564

(56) References cited:
- EP-A1- 2 073 279
- WO-A1-2010/140371
- WO-A2-2011/101682
- JP-A- H0 983 006
- JP-A- H1 051 020
- JP-A- H10 150 213
- JP-A- H10 150 213
- JP-A- S56 169 373
- JP-A- 2004 221 119
- JP-A- 2010 050 341
- US-A- 4 638 110
- US-A1- 2009 183 762
- US-A1- 2010 018 568
- US-A1- 2012 055 551
- US-A1- 2012 074 463

## Description

### Technical Field

The present invention relates to a solar cell and a manufacturing method thereof.

### Background Art

A multi-junction III-V compound solar cell unit is a solar cell which has the highest efficiency among solar cells and which is suitable for a concentrating solar cell. There are several known types of solar cells having such a multi-junction III-V compound solar cell unit (see, PTL 1 and PTL 2, for example). FIG. 19 to FIG. 22 illustrate schematic diagrams of a cross-sectional structure of a conventional solar cell having a multi-junction III-V compound solar cell unit.

FIG. 19 illustrates a first example of a conventional solar cell (see PTL 1). Solar cell 100 illustrated in FIG. 19 has optical component 110 which concentrates sunlight and back sheet 140. Optical component 110 is comprised of a Cassegrain type glass lens. At part of this glass lens, recess 113 for holding solar cell unit 120 is formed.

Back sheet 140 is bonded to optical component 110. Back sheet 140 is comprised of circuit board 150 and adhesion layer 155. Circuit board 150 is comprised of insulator 153 and conductor 154. Solar cell unit 120 is electrically and physically connected to electrode portions 154A and 154B of conductor 154 by way of first connection portion 124A and second connection portion 124B.

FIG. 20 illustrates a second example of a conventional solar cell (see PTL 2). Solar cell 200 illustrated in FIG. 20 has an optical component 210 which concentrates sunlight and primary mirror 230 which is integrated with optical component 210. Optical component 210 is comprised of a Cassegrain type glass lens.

Primary mirror 230 is comprised of two metal films 231 and 234 arranged across gap 237. Primary mirror 230 is formed in a bowl shape. A flat portion at the bottom of primary mirror 230 has aperture 239. Aperture 239 serves as a passage of concentrated sunlight. Solar cell unit 220 for receiving sunlight which has passed through aperture 239 is fixed at an outside of the bottom of primary mirror 230. One of double-sided electrodes of solar cell unit 220 is connected to a wire using a die bonding method, while the other electrode is connected to the wire using a wire bonding method.

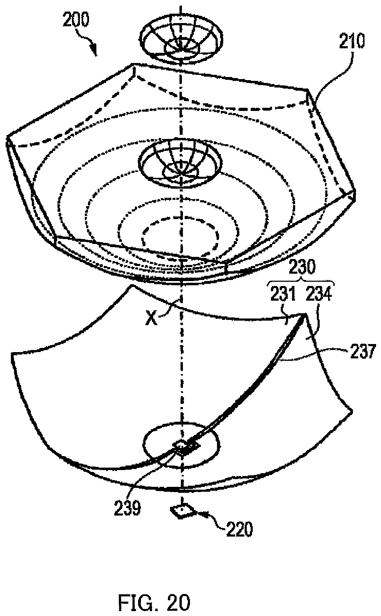

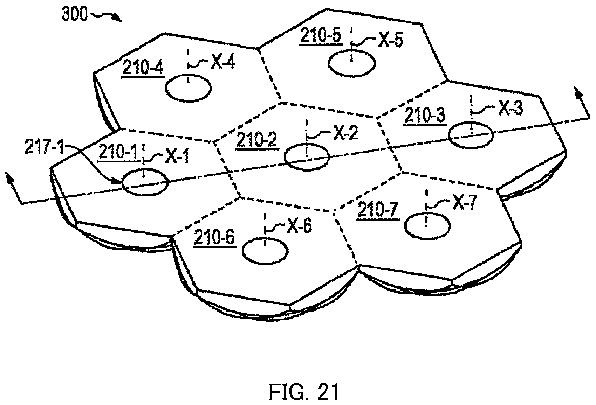

FIG. 21 illustrates solid transparent optical panel 300 which is an array of solar cells 200 illustrated in FIG. 20. Optical component 210 of solar cell 200 has a hexagonal shape. A plurality of optical components 210 (210-1 to 210-7) are adjacent to each other to form one panel-like array.

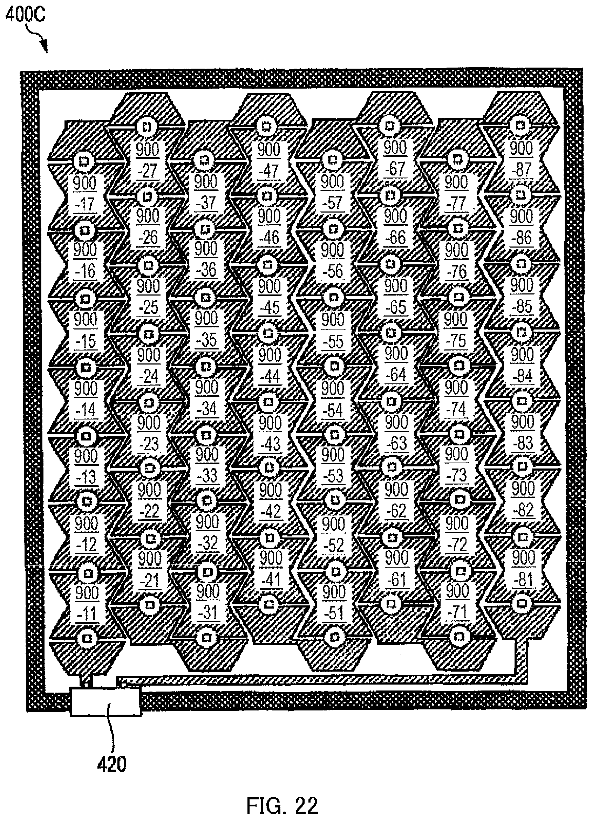

FIG. 22 illustrates concentrating light energy collecting unit 400C which is an array of solar cells 200 illustrated in FIG. 20. In concentrating light energy collecting unit 400C, solar cells 200 are connected to each other by metal films 900-11 to 900-87. That is, a p-side electrode of one of two adjacent solar cells 200 is electrically connected to an n-side electrode of the other of two adjacent solar cells 200. Concentrating light energy collecting unit 400C is composed of a plurality of solar cells 200 connected in series. Power generated at concentrating light energy collecting unit 400C is drawn outside through socket connector 420.

Besides the above-described techniques, various techniques are disclosed as a technique relating to a multi-junction compound solar cell (see PTL 3 to PTL 6, for example). For example, PTL 3 discloses an extraction electrode structure of a thin-film solar cell in which a first electrode is electrically connected to a second electrode via a conducting groove provided inside of a laminated body. According to this invention, it is possible to reduce an area of the extraction electrode portion. However, this electrode structure is provided on the first electrode which extends from a connection termination portion of a plurality of solar cell units connected in series, and does not provide a surface area improvement for receiving sunlight of each solar cell unit.

For example, PTL 4 discloses a solar cell module provided with a plurality of solar cell units, in which a lower electrode (backside electrode) of each solar cell unit (a tandem type photoelectric conversion cell) is electrically connected to a transparent electrode (a light receiving surface electrode) of a solar cell unit adjacent to the solar cell unit via a lattice electrode. According to this invention, it is possible to connect a plurality of solar cell units in series using lattice electrodes. However, this invention cannot provide a surface area improvement for receiving sunlight of each solar cell unit.

PTL 5 discloses a solar cell including a condenser lens, a solar cell element and a column-like optical member. Light concentrated by the condenser lens passes through the column-like optical member and is guided to the solar cell element.

PTL 6 discloses a solar cell module which is integrated by connecting a plurality of unit cells in series, the unit cells being formed by laminating a thin film silicon photoelectric conversion unit and a compound semiconductor photoelectric conversion unit.

PTL 7 (US 2009/183762 A1) discloses a solar concentrator including at least one optical element for concentrating incident light, a receiver assembly comprising a base plate comprising a first conductive layer and second conductive layer, wherein the first conductive layer and second conductive layer are characterized by a voltage differential when exposed to light, and a plurality of photovoltaic cells mounted to the base plate, each cell comprising a first terminal connected to the first conductive layer and a second terminal connected to the second conductive layer, a frame, step-up voltage means, electrically connected to the receiver assembly, for increasing said voltage differential, an electrical circuit for conducting current generated by the receiver assembly, the circuit comprising a first conductive member configured to conduct electricity between the first conductive layer and step-up voltage means and a second conductive member configured to conduct electricity between the second conductive layer and step-up voltage means.

PTL 8 (US 2010/018568 A1) discloses a stacked solar battery device including a plurality of solar battery units, an enclosure case made of a metal plate to house these solar battery units therein, a cover glass having a partial cylindrical lens formed. The plurality of solar battery units are housed in a plurality of recesses of the enclosure case and are sealed with a sealing material of synthetic resin. The solar battery unit has a planar light receiving solar battery module, and rod light receiving solar battery modules stacked so that the module having a shorter center wavelength of the sensitivity wavelength band is positioned closer to the incident side of the sunlight. The solar battery module is configured so that five planar light receiving solar-battery cells are connected in parallel with four connection rods, and the sunlight modules are configured so that five sub modules are connected in parallel respectively with the connection rods. The sub modules are configured so that a plurality of rod-shaped solar battery cells respectively are connected in series.

PTL 9 (EP 2 073 279 A1) discloses a solar cell including a concentrating solar cell element that generates power by converting sunlight into electricity; and a receiver substrate on which the solar cell element is placed. A covering portion that covers and protects the solar cell element is formed on the receiver substrate. The covering portion includes an U-shaped sealing frame that is formed on a surface of the receiver substrate, has an opening, and surrounds the periphery of the solar cell element at a position away from the periphery; a light-transmitting covering plate that is bonded to the sealing frame and covers the solar cell element; and a resin sealing portion in which a sealing region defined by the sealing frame and the light-transmitting covering plate is filled with sealing resin.

### Citation List

### Patent Literature

PTL 1 US Patent Application Publication No. 2007/0256726
PTL 2 Japanese Patent Application Laid-Open No. 2006-303494
PTL 3 Japanese Patent Application Laid-Open No. 2006-13403
PTL 4 Japanese Patent Application Laid-Open No. 2008-34592
PTL 5 Japanese Patent Application Laid-Open No. 2009-187971
PTL 6 WO 2010/101030
PTL 7 US 2009/183762 A1
PTL 8 US 2010/018568 A1
PTL 9 EP 2 073 279 A1

### Summary of Invention

### Technical Problem

In a step of bonding solar cell units to a lens having a curved surface shape in the conventional multi-junction compound solar cell, each solar cell unit is individually bonded to the lens one by one. That is, it is impossible to collectively bond a plurality of solar cell units, which results in a long production lead time.

Further, a solar cell unit of the conventional multi-junction compound solar cell has a surface electrode formed of a metal material such as Au, Ni and Ge which does not transmit sunlight, on a surface of a top cell. Therefore, the solar cell unit has a reduced amount of sunlight incident thereon, which may lead to decrease in efficiency of power generation from sunlight of the solar cell unit.

Still further, in the conventional multi-junction compound solar cell, the condenser lens is provided away from the solar cell unit. It is therefore difficult to dissipate heat of the condenser lens generated by sunlight, which may lead to increase in a risk of deterioration of the condenser lens by heat. Accordingly, it is necessary to use the condenser lens formed of a material having high heat resistance, or it is necessary to provide a heat sink for heat dissipation.

Therefore, an object of the present invention is to provide a solar cell which realizes a short production lead time, excels in heat dissipation properties and has high power generation efficiency.

### Solution to Problem

The problem of the invention is solved by the subject-matter of claims 1 and 7.

### Advantageous Effects of Invention

According to the present invention, it is possible to provide a solar cell which realizes a short production lead time, excels in heat dissipation properties and has high power generation efficiency.

### Brief Description of Drawings

FIG. 1 is a simplified schematic cross-sectional diagram of a solar cell according to an embodiment;
FIG. 2 is an enlarged view of the schematic cross-sectional diagram of the solar cell according to the embodiment;
FIG. 3 schematically illustrates a configuration of a solar cell unit according to the embodiment;
FIG. 4 illustrates a schematic configuration of a cell laminate and an absorption wavelength in each cell layer according to the embodiment;
FIGS. 5A, 5B, 5C and 5D illustrate a step of providing a solar cell unit in a method for manufacturing the solar cell unit according to the embodiment;
FIGS. 6A, 6B and 6C illustrate a step of providing a solar cell unit in the method for manufacturing the solar cell unit according to the embodiment;
FIGS. 7A, 7B and 7C illustrate a step of providing a solar cell unit in the method for manufacturing the solar cell unit according to the embodiment;
FIGS. 8A, 8B and 8C illustrate a step of providing a solar cell unit in the method for manufacturing the solar cell unit according to the embodiment;
FIGS. 9A, 9B, 9C and 9D illustrate a step of providing a solar cell unit in the method for manufacturing a solar cell unit according to the embodiment;
FIG. 10 illustrates a step of providing a glass plate in the method for manufacturing a solar cell unit according to the embodiment;
FIG. 11 illustrates a step of bonding the solar cell unit to the glass plate in the method for manufacturing the solar cell unit according to the embodiment;
FIG. 12 illustrates a step of attaching the solar cell unit to the substrate in the method for manufacturing the solar cell unit according to the embodiment;
FIG. 13 illustrates a step of attaching the solar cell unit to the substrate in the method for manufacturing the solar cell unit according to the embodiment;
FIG. 14 illustrates a step of attaching the solar cell unit to the substrate in the method for manufacturing the solar cell unit according to the embodiment;
FIG. 15 illustrates a step of attaching the solar cell unit to the substrate in the method for manufacturing the solar cell unit according to the embodiment;
FIG. 16 illustrates a step of bonding a fly-eye lens to the glass plate in the method for manufacturing the solar cell unit according to the embodiment;
FIG. 17 illustrates a step of bonding the fly-eye lens to the glass plate in the method for manufacturing the solar cell unit according to the embodiment;
FIG. 18 illustrates simplified a state where the solar cell is placed according to the embodiment;

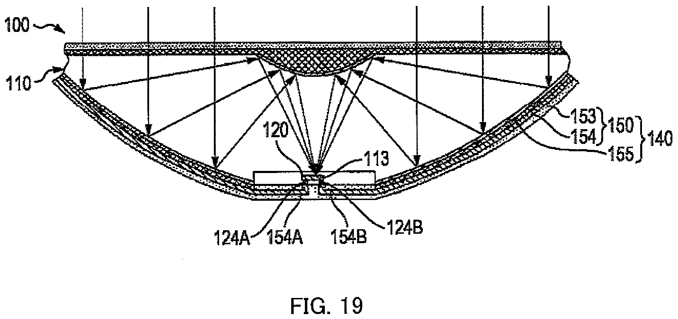

FIG. 19 schematically illustrates a configuration of a first example of a conventional solar cell;
FIG. 20 schematically illustrates a configuration of a second example of a conventional solar cell structure;
FIG. 21 schematically illustrates a configuration of a third example of a conventional solar cell structure; and
FIG. 22 schematically illustrates a configuration of a fourth example of a conventional solar cell structure.

### Description of Embodiments

While the present invention will be explained using embodiments, the present invention is not limited to the following embodiments. In the accompanying drawings, the same or similar reference numerals are assigned to the components having the same or similar functions, and their explanation will be omitted. The accompanying drawings schematically illustrate the invention. Therefore, a specific dimension, or the like is not limited by the accompanying drawings.

### <Solar Cell>

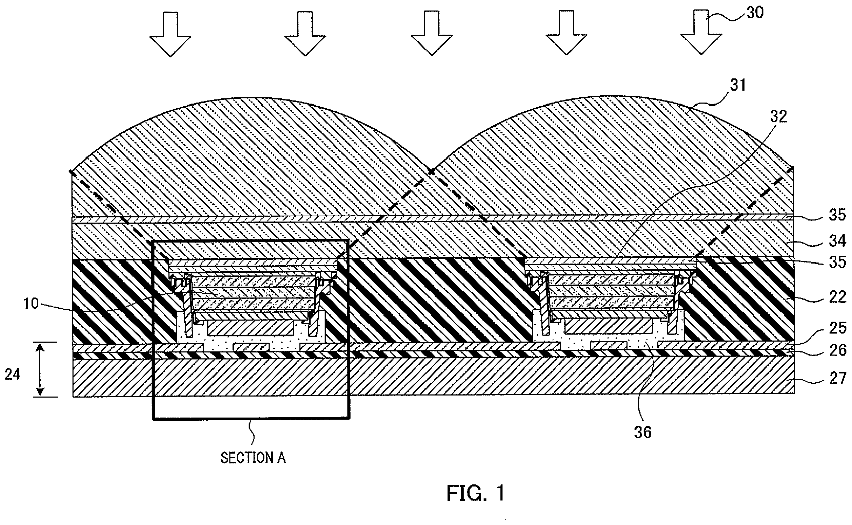

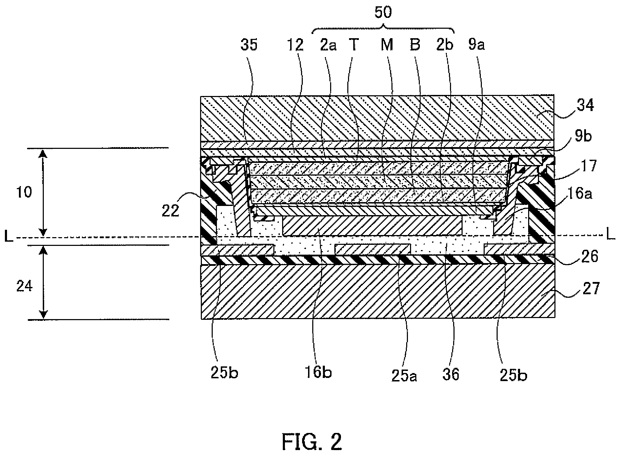

FIG. 1 is a simplified schematic cross-sectional diagram of a solar cell according to an embodiment. FIG. 2 is a partial cross-sectional diagram of the solar cell according to the embodiment. As illustrated in FIG. 1 and FIG. 2, the solar cell according to the embodiment has (1) substrate 24, (2) a plurality of (two) multi-junction solar cell units 10 attached to substrate 24, (3) glass plate 34 disposed on transparent electrode 12 of solar cell units 10 via a transparent adhesive, and (4) condenser lens 31 which is disposed on glass plate 34 via transparent adhesive 35.

### (1) Substrate

As illustrated in FIG. 2, substrate 24 has plate-like base 27 having heat dissipation properties, first insulating layer 26 disposed on base 27, first conductive line 25a and second conductive line 25b which are disposed on first insulating layer 26 so as to be electrically insulated. The heat dissipation properties of base 27 are expressed by, for example, thermal conductivity. The thermal conductivity of base 27 is preferably 1.0 W/(m·K) or higher, and more preferably, 2.0 W/(m·K) or higher so that heat of a lens can be effectively dissipated. The thermal conductivity of base 27 is preferably, for example, 2 to 8 W/(m·K).

Examples of base 27 include a metal plate or a ceramic plate having heat dissipation properties. Specifically, base 27 can be an aluminum base substrate or an iron base substrate. The thickness of base 27 is preferably, for example, 1.0 to 1.5 mm.

First conductive line 25a and second conductive line 25b are electrically independent of each other. First conductive line 25a and second conductive line 25b can be formed on base 27 by a normal method for forming a conductive layer such as a metal layer in a desired shape. Each thickness of first conductive line 25a and second conductive line 25b is preferably 18 to 36 µm from the viewpoint of voltage resistance.

First conductive line 25a and second conductive line 25b are comprised of, for example, a copper layer having a desired planar shape and an Ni-Au layer which has been subjected to Ni or Au plate processing. The thickness of the copper layer is, for example, 10 to 50 µm. The Ni-Au layer is formed by a flash Au plating method or an electrolytic Au plating method. The thickness of the Ni-Au layer is, for example, 0.5 µm at a maximum.

First conductive line 25a and second conductive line 25b are electrically independent of each other. First conductive line 25a is electrically connected to later-described central electrode 16b in solar cell unit 10. Second conductive line 25b is electrically connected to later-described side electrode 16a in solar cell unit 10.

When base 27 has conductive property, substrate 24 may further have an insulating layer (hereinafter, also referred as "first insulating layer 26") on a surface of base 27. First insulating layer 26 may be formed on the entire surface of base 27 or may be formed only around first conductive line 25a and second conductive line 25b so as to increase heat dissipation properties. First insulating layer 26 can be formed using a normal method for forming a layer having a desired planar shape on a plate-like member. Examples of a material of first insulating layer 26 include epoxy resins, phenol resins, fluorine-based resins, polyimide resins, silicone resins and acrylic resins. If the material of the first insulating layer is a resin material, the thickness of first insulating layer 26 is preferably 15 µm to 300 µm so as to ensure sufficient insulation performance and heat-transfer performance between the above-described conductive lines and base 27.

First insulating layer 26 is formed by applying an insulating layer coating material to base 27. First insulating layer 26 is formed so as not to be aerated and so as not to cause a defect such as a pinhole defect to maintain electric insulation.

### (2) Solar Cell Unit

As illustrated in FIG. 2, solar cell unit 10 has lower electrode 9a which is bonded and electrically connected to first conductive line 25a; cell stack 50 including bottom cell layer B disposed on an upper surface of lower electrode 9a, middle cell layer M disposed on an upper surface of bottom cell layer B, and top cell layer T disposed on an upper surface of middle cell layer M; transparent electrode 12 disposed on an upper surface of top cell layer T; insulating layer 17 disposed on a side surface of cell stack 50; and side electrode 16a disposed on the side surface of cell stack 50 via insulating layer 17 so as to electrically connect transparent electrode 12 and second conductive line 25b.

Cell stack 50 may include at least bottom cell layer B and top cell layer T. That is, middle layer M in cell stack 50 may be omitted. Further, solar cell unit 10 may have a conductor for connecting transparent electrode 12 to second conductive line 25b in place of side electrode 16a. This conductor is, for example, a wire for wire bonding.

Since use of solar cell unit 10 eliminates the necessity for providing electrodes other than transparent electrode 12 on a sunlight receiving surface, usage efficiency of sunlight is improved.

While lower electrode 9a is electrically connected to first conductive line 25a, lower electrode 9a may be in contact with first conductive line 25a or may be connected to first conductive line 25a via a conductive member. Further, while side electrode 16a is electrically connected to second conductive line 25b, side electrode 16a may be in contact with second conductive line 25b or may be connected to second conductive line 25b via a conductive member.

Solar cell unit 10 may have additional members within a range in which an effect of the present invention can be provided. For example, solar cell unit 10 may have central electrode 16b on a lower surface of lower electrode 9a in order to improve electrical contact between lower electrode 9a and first conductive line 25a.

Further, solar cell unit 10 may have lower contact layer 2b between lower electrode 9a and bottom cell layer B in order to improve electrical contact between bottom cell layer B and lower electrode 9a. Still further, solar cell unit 10 may have upper contact layer 2a between top cell layer T and transparent electrode 12 in order to improve electrical contact between top cell layer T and transparent electrode 12. The material of the contact layers can be appropriately selected according to the materials of top cell layer T and bottom cell layer.

Further, solar cell unit 10 may have an Au/Ti laminated film (which is not illustrated) between second insulating layer 17 and side electrode 16a. Still further, solar cell unit 10 may have upper electrode 9b for electrically connecting transparent electrode 12 and side electrode 16a.

Transparent electrode (ZnO) 12 provided on an upper surface of upper contact layer 2a of cell stack 50 draws a potential of top cell layer T. Upper electrode 9b is connected to transparent electrode 12. Side electrode 16a is connected to upper electrode 9b. Insulating layer 17 is provided between side electrode 16a and the cell stack, which are insulated from each other. Insulating layer 17 is a silicon nitride film, or the like.

A lower surface of side electrode 16a is preferably positioned below a lower surface of lower electrode 9a. More preferably, the lower surface of side electrode 16a corresponds with a lower surface of central electrode 16b on dashed line LL. That is, electrical connection portions with external parts (an electrical connection portion having a potential of a top cell and an electrical connection portion having a potential of a bottom cell) are preferably drawn out on one surface.

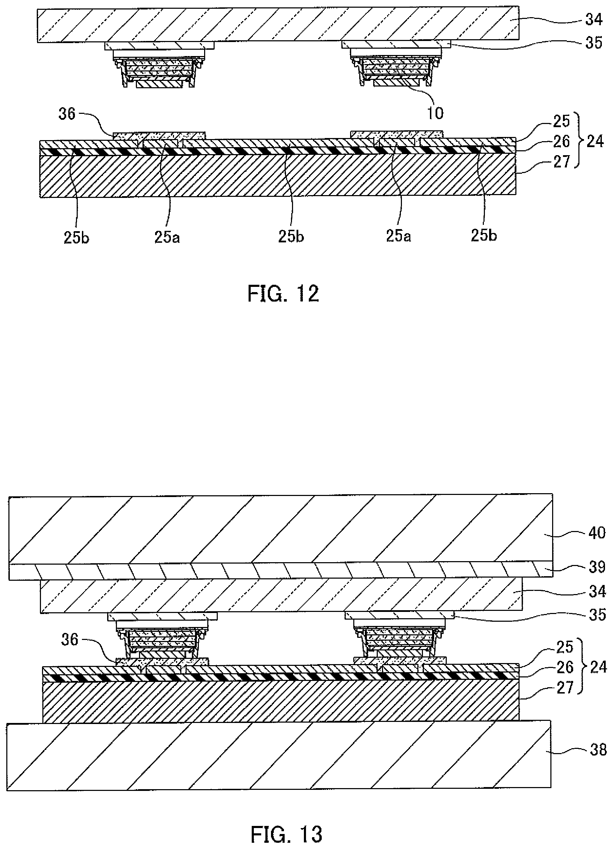

By this means, when solar cell unit 10 is attached to substrate 24 (see FIG. 12 and FIG. 13), it is possible to prevent breakage of solar cell unit 10 even if pressure is evenly applied to solar cell unit 10. That is, when side electrode 16a having a potential generated at top cell layer T and central electrode 16b having a potential generated at bottom cell layer B are disposed on the same plane, it is possible to attach side electrode 16a and central electrode 16b with an external electrode at one time in a production step, which can shorten a production lead time.

The lower surface of side electrode 16a and the lower surface of central electrode 16b which are disposed on the same plane are respectively electrically connected to first conductive line 25a and second conductive line 25b of substrate 24 with or without an interposed conductive member. Side electrode 16a and central electrode 16b are disposed to be electrically independent of each other.

In the solar cell according to the embodiment, electrical connection between lower electrode 9a and first conductive line 25a and electrical connection between side electrode 16a and second conductive line 25b are achieved via anisotropic conductive material 36. Use of anisotropic conductive material 36 enables adhesion and electrical connection between substrate 24 and solar cell unit 10 at the same time and easily. Anisotropic conductive material 36 is, for example, a thermosetting resin film (ACF) in which conductive particles are dispersed and an anisotropic conductive paste (ACP).

As illustrated in FIG. 1 and FIG. 2, a gap between substrate 24 and glass plate 34 is preferably sealed with sealing resin 22 so as to improve mechanical strength and chemical resistance, and further to suppress concentration of stress due to heating of lens under insolation. Sealing resin 22 improves structural strength of a structure comprised of substrate 24, solar cell unit 10 and glass plate 34. Examples of sealing resin 22 include an epoxy resin, a phenol resin, a fluorine-based resin, a polyimide resin, a silicon resin and an acrylic resin.

Lower electrode 9a and upper electrode 9b are conductive members such as metals. Lower electrode 9a and upper electrode 9b are, for example, Au plating films each having a thickness of about 10 µm. Central electrode 16b and side electrode 16a are, for example, Au plating films each having a thickness of about 10 to 50 µm. Central electrode 16b and side electrode 16a are formed to be thicker than lower electrode 9a and upper electrode 9b. Second insulating layer 17 is, for example, an SiN film having a thickness of about 1 µm. Transparent electrode 12 is, for example, a ZnO layer having a thickness of about 0.5 µm. The thickness of the Au/Ti laminated film is about 0.5 µm.

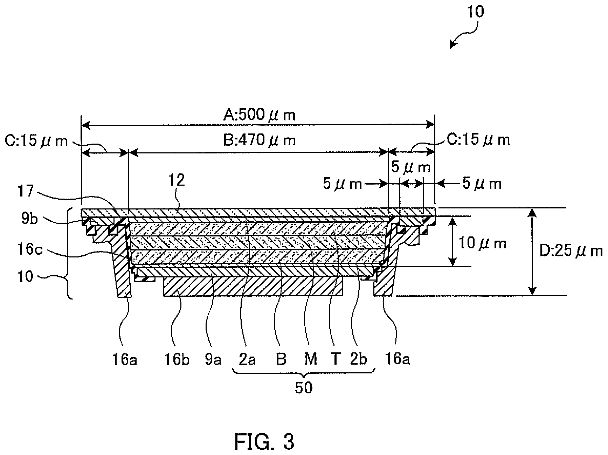

As illustrated in FIG. 3, width A of transparent electrode 12 is, for example, 500 µm. Width B of upper contact layer 2a is, for example, 470 µm. Width C of a peripheral portion of transparent electrode 12 is, for example, 15 µm. A width of upper electrode 9b disposed at the center of the peripheral portion is, for example, 5 µm. A width of a gap between upper electrode 9b and cell stack 50 is, for example, 5 µm. A width between upper electrode 9b and an edge of transparent electrode 12 is, for example, 5 µm. The thickness of cell stack 50 is, for example, 10 µm. Thickness D of solar cell unit 10 is, for example 25 µm.

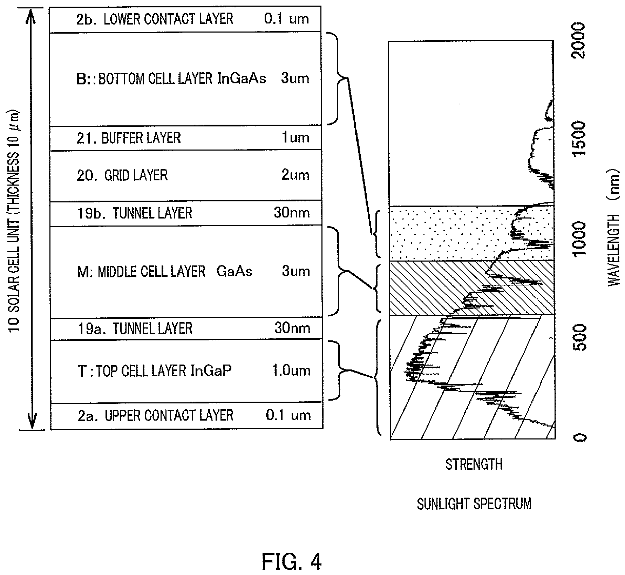

As illustrated in FIG. 4, cell stack 50 is comprised of upper contact layer 2a, top cell layer T, tunnel layer 19a, middle cell layer M, tunnel layer 19b, grid layer 20, buffer layer 21, bottom cell layer B and lower contact layer 2b. As described above, middle cell layer M may be omitted.

A forbidden bandwidth of top cell layer T is 1.87 eV, and a wavelength which can be absorbed in a sunlight spectrum is in a range of 650 nm or less. A forbidden bandwidth of middle cell layer M is 1.41 eV, and a wavelength which can be absorbed in the sunlight spectrum is in a range from 650 nm to 900 nm. A forbidden bandwidth of bottom cell layer B is 1.0 eV, and a wavelength which can be absorbed in the sunlight spectrum is in a range from 900 nm to 1,200 nm. In this way, by forming the cell stack of the solar cell unit to have a three-layer structure including top cell layer T, middle cell layer M and bottom cell layer B, the sunlight spectrum can be effectively utilized, so that it is possible to realize a high-efficient solar cell.

Transparent electrode 12 is formed on top cell layer T of cell stack 50. Transparent electrode 12 can be formed using a normal method for forming transparent electrode 12 at a desired position. Materials of transparent electrode 12 include, for example, zinc oxide (ZnO), ITO, IZO and a graphene transparent conductive film.

Insulating layer 17 (hereinafter, referred to as a "second insulating layer") in solar cell unit 10 is formed on a side surface of cell stack 50. Second insulating layer 17 may be formed in a range from the side surface of cell stack 50 to the side surface of lower electrode 9a. Materials of second insulating layer 17 include, for example, SiN, BN, SiO and the same materials as those of first insulating layer 26.

Side electrode 16a is formed on second insulating layer 17 at a lateral side of cell stack 50. Side electrode 16a may be formed away from second insulating layer 17. Materials of side electrode 16a can include those used as materials of lower electrode 9a. Side electrode 16a is preferably formed to reach a lateral side of lower electrode 9a (but to be separated from the lower electrode) so as to electrically connect to the conductive lines on the substrate surface more easily.

### (3) Glass Plate

Solar cell unit 10 is bonded to a predetermined position which is a focal point of sunlight in glass plate 34 via a transparent adhesive. In order to ensure that solar cell unit 10 is fixed at the predetermined position, it is preferable to form a "hydrophilic area" where the transparent adhesive can be applied and a "water-repellent area" where the transparent adhesive is repelled on the surface of glass plate 34, and then, to bond solar cell unit 10 as will be described later.

It is preferable to form a polytetrafluoroethylene (PTFE) layer in the "water-repellent area" and modify the surface of the glass plate so that the "hydrophilic area" has a hydroxy group (-OH). The "hydrophilic area and the water-repellent area" may be formed using a photolithography method. For example, the "hydrophilic area and the water-repellent area" can be formed by performing patterning using a photosensitive resist and performing wet etching on the patterned area.

Glass plate 34 can be a glass material such as soda-lime glass, alkali-borosilicate glass, alkali-free glass, silica glass, low-expansion glass, zero-expansion glass and crystalized glass which are available for solar cells. Further, glass plate 34 can be various tempered glasses such as a glass for TFT, a glass for PDP, a base glass for optical filter, a figured glass and a chemically strengthened glass.

### (4) Lens

Lens 31 is bonded to glass plate 34 via an adhesive. Lens 31 is a fly-eye lens, which has a plurality of focal points on a side opposite to the light receiving surface.

Lens 31 is formed of a transparent material. Examples of the material of lens 31 include a glass and a transparent resin. The transparent resin can be, for example, an acrylic resin, a silicone resin or a polycarbonate resin. The material of lens 31 is preferably an inorganic material such as glass from the viewpoint of heat resistance. Meanwhile, the material of lens 31 is preferably a transparent resin from the viewpoint of reduction in weight. Among the transparent resins, it is preferable to use an acrylic resin from the viewpoint of productivity and economic efficiency.

Lens 31 is a fly-eye lens comprised of a plurality of plano-convex lenses arranged on a plane. Each plano-convex lens has a focal point on a surface on a side opposite to the incidence surface, which is transparent electrode 12 of solar cell unit 10. A planar shape of lens 31 is a square of about 50 mm each side. The thickness of lens 31 is, for example, 7 mm.

The size of each lens and the number of focal points in lens 31 (fly-eye lens) are set according to a light condensing magnification of each lens. For example, when the light condensing magnification of each lens is 400 times, the size of each lens is a 10 mm square. Therefore, lens 31 has 25 (5 × 5) lenses. When the light condensing magnification of each lens is 1,000 times, the size of each lens is a 16 mm square. Therefore, lens 31 has 9 (3 × 3) lenses.

The transparent resin contains, for example, an ultraviolet absorbing agent. Therefore, even if lens 31 is placed under insolation for a long period of time, the color of lens 31 does not change to yellow, and it is possible to secure transparency.

A plurality of multi-junction solar cell units is disposed on a single substrate and as lens 31 a fly-eye lens is employed in which focal points are provided at the transparent electrodes of the plurality of multi-junction solar cell units, respectively.

Lens 31 has a recess at a part of a boundary region with the transparent adhesive. The recess is provided at a region other than a region where light is transmitted. The recess can trap air bubbles in the transparent adhesive and prevent the air bubbles from flowing into a light transmitting portion of the lens.

### (5) Transparent Adhesive

Transparent adhesive 35 is used for adhesion between lens 31 and glass plate 34 and adhesion between glass plate 34 and solar cell unit 10. Specifically, transparent electrode 12 of solar cell unit 10 is bonded to one face of glass plate 34 using transparent adhesive 35, and a surface of lens 31 on a side opposite to the light receiving surface is bonded to the other face of glass plate 34.

Transparent adhesive 35 is formed of an epoxy material or a silicone material. As transparent adhesive 35, for example, a two-liquid adhesive is used which includes a base compound comprised of a resin material and a curing agent which is comprised of a resin material and which is to be mixed into the base compound, or a resin material which cures by ultraviolet rays is used.

### (6) Other Points

Further, the solar cell according to the embodiment has a configuration in which a plurality of solar cell units 10 are attached to single substrate 24 and a fly-eye lens which has focal points respectively at a plurality of transparent electrodes 12 is used as lens 31. Substrate 24 to which the plurality of solar cell units 10 are attached has first conductive line 25a and second conductive line 25b at a position where each solar cell unit 10 is disposed.

The fly-eye lens is composed of lenses molded such that a plurality of plano-convex lenses are arranged in parallel.

The solar cell according to the embodiment has a side electrode and a base. Heat on a side of the incidence surface (for example, lens) of the solar cell unit is transferred to the base via the side electrode. Since the base has heat dissipation properties, the transferred heat is quickly dissipated to outside. Therefore, the solar cell according to the embodiment has excellent heat dissipation properties.

In the solar cell according to the embodiment, a plurality of solar cell units bonded to a flat glass plate with little variation in thickness are attached to the substrate. That is, it is possible to collectively attach a plurality of solar cell units and it is not necessary to attach the solar cell units one by one individually, so that it is possible to shorten a production lead time.

Further, the solar cell unit according to the embodiment does not have a surface electrode on a surface of the top cell. Therefore, according to the present invention, it is possible to increase a surface area for receiving sunlight of the solar cell unit.

### <Method for Manufacturing Solar Cell>

A method for manufacturing a solar cell includes (1) providing a substrate, (2) providing a plurality of multi-junction solar cell units, (3) providing a glass plate, (4) bonding the plurality of solar cell units to the glass plate, (5) attaching the plurality of solar cell units bonded to the glass plate to the substrate, (6) providing a sheet-like condenser lens having a plurality of focal points, and (7) bonding the condenser lens to the glass plate.

### (1) Step of Providing Substrate

Substrate 24 has, for example, base 27 and first conductive line 25a and second conductive line 25b which are disposed on base 27 so as to be electrically independent of each other. Each conductive line can be formed using a normal method for forming a metal layer having a desired planar shape. Further, if base 27 has conductive property, first insulating layer 26 is formed between base 27 and the conductive lines.

### (2) Step of Providing Solar Cell Unit

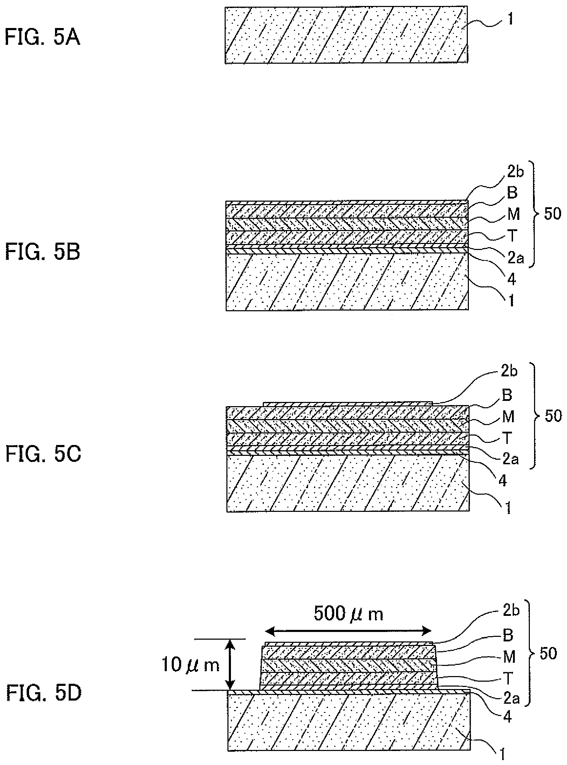

First, disc-like GaAs substrate 1 (a wafer) illustrated in FIG. 5A is provided. GaAs substrate 1 has a size of, for example, a diameter of 4 inches (10.16 cm) and a thickness of 500 µm. Typically, a plurality of solar cell units 10 are formed on one GaAs substrate 1.

### Manufacturing of Cell Stack

As illustrated in FIG. 5B, cell stack 50 is formed on GaAs substrate 1 via sacrificial layer 4. As previously explained using FIG. 4, cell stack 50 can be obtained by, for example, forming upper contact layer 2a, top cell layer T, tunnel layers 19a and 19b, middle cell layer M, grid layer 20, buffer layer 21, bottom cell layer B and lower contact layer 2b on sacrificial layer 4 through epitaxial growth. The height of obtained cell stack 50 is, for example, 10 µm. Cell stack 50 can be obtained by forming each metal layer on GaAs substrate 1. Each metal layer is put into a vertical Metal Organic Chemical Vapor Deposition (MOCVD) device and can be formed using an epitaxial growth method.

Epitaxial growth of each metal layer is performed using a normal method. For example, the method is performed at an ambient temperature of about 700°C. As materials for causing growth of the GaAs layer, tri-methyl gallium (TMG) and arsine (AsH3) can be used. As materials for causing growth of an InGaP layer, tri-methyl indium (TMI), TMG and phosphine (PH3) can be used. Further, as impurities for forming an n-type GaAs layer, an n-type InGaP layer and an n-type InGaAs layer, monosilane (SiH₄) can be used. Meanwhile, as impurities for forming a p-type GaAs layer, a p-type InGaP layer and a p-type InGaAs layer, diethyl zinc (DEZn) can be used.

Specifically, cell stack 50 can be manufactured through the following steps. An AlAs layer having a thickness of about 100 nm is epitaxially grown on GaAs substrate 1 as sacrificial layer 4. Then, an n-type InGaP layer having a thickness of about 0.1 µm is grown as upper contact layer 2a.

Subsequently, top cell layer T is formed. An n-type InAlP layer having a thickness of about 25 nm as a window, an n-type InGaP layer having a thickness of about 0.1 µm as an emitter, a p-type InGaP layer having a thickness of about 0.9 µm as a base, and a p-type InGaP layer having a thickness of about 0.1 µm as a BSF are formed using an epitaxial growth method. As a result, top cell layer T having a thickness of about 1 µm is formed.

After top cell layer T is formed, a p-type AlGaAs layer having a thickness of about 12 nm and an n-type GaAs layer having a thickness of about 20 nm are grown as tunnel layer 19. As a result, tunnel layer 19 having a thickness of about 30 nm is formed.

Subsequently, middle cell layer M is formed. An n-type InGaP layer having a thickness of about 0.1 µm as a window; an n-type GaAs layer having a thickness of about 0.1 µm as an emitter, a p-type GaAs layer having a thickness of about 2.5 µm as a base; and a p-type InGaP layer having a thickness of about 50 nm as a BSF are formed using the epitaxial growth method. As a result, middle cell layer M having a thickness of about 3 µm is formed.

After middle cell layer M is formed, a p-type AlGaAs layer having a thickness of about 12 nm and an n-type GaAs layer having a thickness of about 20 nm are grown as tunnel layer 19. As a result, tunnel layer 19 having a thickness of about 30 nm is formed.

Subsequently, grid layer 20 is formed. Grid layer 20 suppresses occurrence of dislocation and missing due to mismatching of a lattice constant. Eight layers of n-type InGaP layers each having a thickness of about 0.25 µm are formed to form grid layer 20 having a thickness of about 2 µm. Further, an n-type InGaP layer having a thickness of about 1 µm is formed as buffer layer 21.

Subsequently, bottom cell layer B is formed. An n-type InGaP layer having a thickness of about 50 nm as a passivation film, an n-type InGaAs layer having a thickness of about 0.1 µm as an emitter, a p-type InGaAs layer having a thickness of about 2.9 µm as a base, and a p-type InGaP layer having a thickness of about 50 nm as a passivation film are formed using the epitaxial growth method. As a result, bottom cell layer B having a thickness of about 3 µm is formed. Finally, a p-type InGaAs layer having a thickness of about 0.1 µm is grown as lower contact layer 2b.

As illustrated in FIG. 5C, lower contact layer 2b having a thickness of about 0.1 µm is patterned in a predetermined size. Patterning can be performed through dry etching processing.

As illustrated in FIG. 5D, cell stack 50 having a thickness of 10 µm is patterned in a predetermined planar shape. A size of the patterned planar shape (for example, a diameter in the case of a circle, and a length in the case of a rectangle) is, for example, 500 µm. Patterning is preferably performed through dry etching processing. It is confirmed that when cell stack 50 is disposed in an inner side of an outer edge of GaAs substrate 1, loss of carriers occurring around a solar cell portion can be suppressed and conversion efficiency is improved. A structure as described above in which a cell stack at an edge portion is etched is sometimes referred to as a "Ledge structure". As described in "J. Vac. Sci. Technol. B, Vol. 11, No. 1, Jan/Feb 1993" and "IEICE Technical Report ED2007-217, MW2007-148(2008-1)", it is known that loss of carriers is likely to occur at an edge of a PN junction. To address this problem, by employing the "Ledge structure", carriers are concentrated inside the substrate, so that loss of carriers at the edge is suppressed.

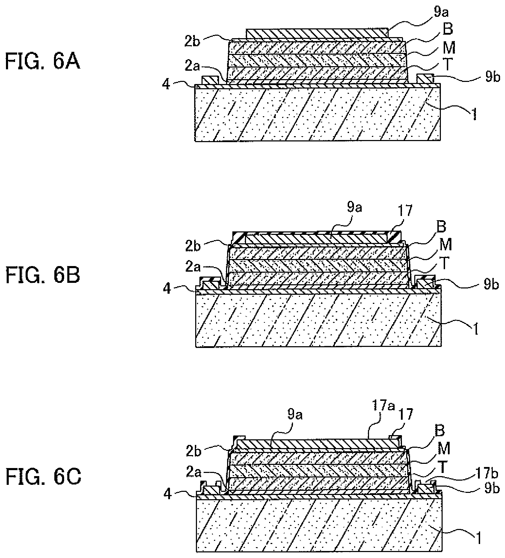

As illustrated in FIG. 6A, an Au plating electrode is formed as upper electrode 9b and lower electrode 9a. Specifically, first, an Au plating film having a thickness of about 10 µm or less is formed on the entire surface of an upper portion of cell stack 50 in FIG. 5D using an electrolytic plating method. The Au plating film is patterned to form upper electrode 9b and lower electrode 9a. Patterning is performed using a combination of photolithography and wet etching.

As illustrated in FIG. 6B, an SiN film is formed as insulating layer 17. The SiN film is formed on the entire surface of the upper portion of the cell stack using, for example, a plasma CVD method.

As illustrated in FIG. 6C, an unnecessary portion of insulating layer 17 is eliminated to form windows 17a and 17b of insulating layer 17. Through windows 17a and 17b of insulating layer 17, Au plated surfaces forming lower electrode 9a and upper electrode 9b are respectively exposed.

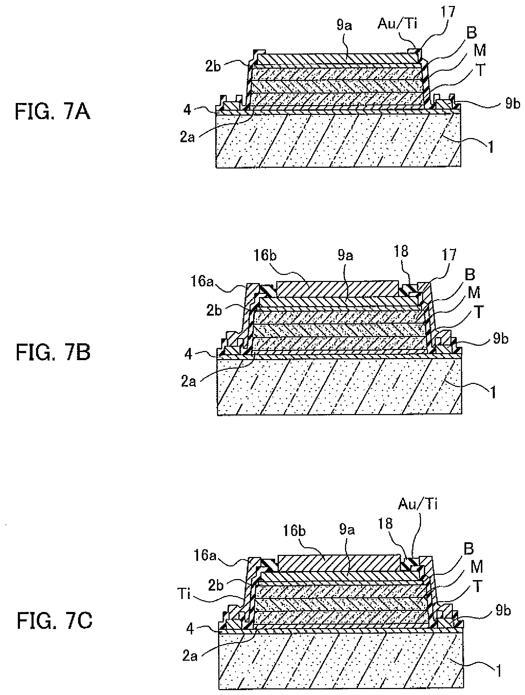

As illustrated in FIG. 7A, an Au/Ti laminated film is formed on the entire surface of the upper portion of the cell stack obtained in FIG. 6C using a metal sputtering method. The Au/Ti laminated film becomes a preprocessing film on which Au will be electrolytically plated in the subsequent step.

As illustrated in FIG. 7B, a portion where the electrolytic Au plating film is not required to be formed is coated with resist 18. For example, the portion where the plating film is not required to be formed is coated with resist 18 for mesa etching through an exposure step and etching using an alkali aqueous solution or an acid solution. Then, the electrolytic Au plating film is formed.

Central electrode 16b and side electrode 16a are formed through electrolytic Au plating. Central electrode 16b and side electrode 16a formed of the Au plating film are thicker than the cell stack of the solar cell unit which has a thickness of 10 µm, and are formed to have a thickness around 10 to 50 µm.

As illustrated in FIG. 7C, a Ti film for protecting the Au plating is formed. The Ti film may be formed using metal sputtering and is formed on the entire surface of the upper portion of the stack obtained in FIG. 5B.

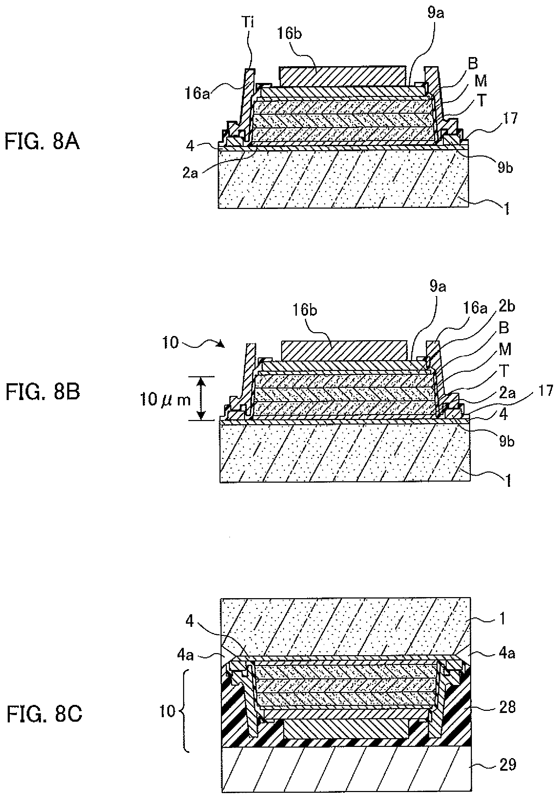

As illustrated in FIG. 8A, resist 18 (FIG. 7C) is removed. Resist 18 is removed through wet processing. It is possible to remove resist 18 alone through etching using an alkali aqueous solution and an acid solution.

As illustrated in FIG. 8B, the Au/Ti film on insulating layer 17 and the Ti film on the Au plated electrode are removed. These films are removed using a dry edge. In this manner, the surface of the Au plated electrode is formed as a clean surface with no organic contamination.

As illustrated in FIG. 8B, a basic structure of the multi-junction compound solar cell unit which is bonded at one side can be obtained. However, in the multi-junction compound solar cell unit which is bonded at one side illustrated in FIG. 8B, top cell layer T is located at a side of GaAs substrate 1, and bottom cell layer B is located at a side of central electrode 16b. In order to allow sunlight to be incident from top cell layer T, it is necessary to peel GaAs substrate 1 from the basic structure of the solar cell unit illustrated in FIG. 8B. Further, at that time, solar cell unit 10 should not be damaged.

### Formation of Recess in Sacrificial Layer

When GaAs substrate 1 is peeled, solar cell unit 10 should not be damaged. Therefore, as illustrated in FIG. 8C, after solar cell unit 10 is inverted upside down so that GaAs substrate 1 side is located upper side in a gravity direction, solar cell unit 10 is disposed on holding plate 29 on which wax 28 is provided. Then, in order to peel GaAs substrate 1, sacrificial layer recess 4a is provided at a side surface of sacrificial layer 4. Since solar cell unit 10 is extremely fragile, there is a case where solar cell unit 10 is destroyed by stress at the time when GaAs substrate 1 is peeled. Therefore, sacrificial layer recess 4a is provided as a starting point for reliably causing internal fracture of sacrificial layer 4. Sacrificial layer recess 4a may be provided by, for example, grinding sacrificial layer 4 using a blade, grinding sacrificial layer 4 using a water jet, or performing mechanical "marking-off". By sealing a gap between solar cell unit 10 and substrate 24 with sealing resin 22, solar cell unit 10 is mechanically strengthened. Therefore, solar cell unit 10 is not destroyed when sacrificial layer recess 4a is formed.

### Peeling of GaAs Substrate

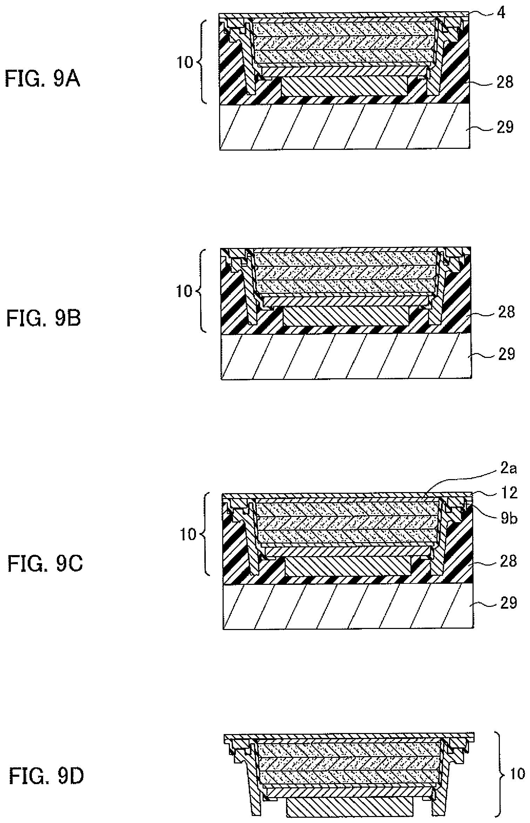

As illustrated in FIG. 9A, GaAS substrate 1 is peeled by causing internal fracture of sacrificial layer 4. Sacrificial layer 4 is internally fractured by utilizing silicon on insulator (SOI) related techniques such as dicing, roller peeling, water jetting and ultrasonic disruption.

A lattice constant of GaAs configuring substrate 1 is 5.653 Å, a lattice constant of AlAs configuring sacrificial layer 4 is 5.661 Å, and both are substantially the same. Therefore, sacrificial layer 4 is a stable film and can be stably internally fractured.

### Etching of Sacrificial Layer

As illustrated in FIG. 9B, sacrificial layer 4 remained in solar cell unit 10 is removed by wet etching. For example, sacrificial layer 4 can be melted and removed by being brought into contact with hydrofluoric acid for 2 to 3 minutes. Since solar cell unit 10 is protected by sealing resin 22, the hydrofluoric acid does not damage solar cell unit 10.

### Formation of Transparent Electrode

As illustrated in FIG. 9C, transparent electrode 12 is formed. Transparent electrode 12 constitutes a sunlight incidence surface. Transparent electrode 12 which is a ZnO layer or an ITO layer, can be formed through a sputtering method. Transparent electrode 12 is formed on the entire surface of an upper portion of solar cell unit 10, and electrically connects upper contact layer 2a and upper electrode 9b. It is also possible to improve conductive property by adding 0.1 mass% or more of Al or Ga to the ZnO layer.

As illustrated in FIG. 9D, wax 28 is removed from solar cell unit 10. Solar cell unit 10 obtained in this manner does not have an electrode which intercepts sunlight, on the sunlight incidence surface. Therefore, the amount of sunlight incident on solar cell unit 10 is increased, and power generation efficiency of solar cell unit 10 is improved.

According to this embodiment, although cell stack 50 of solar cell unit 10 is thin (for example, 10 µm or less), it is possible to form a solar cell by peeling GaAs substrate 1 without damaging cell stack 50.

### (3) Step of Providing Glass Plate

### (3-1) Liquid Repellent Treatment and Hydrophilic Treatment on Surface of Glass Plate

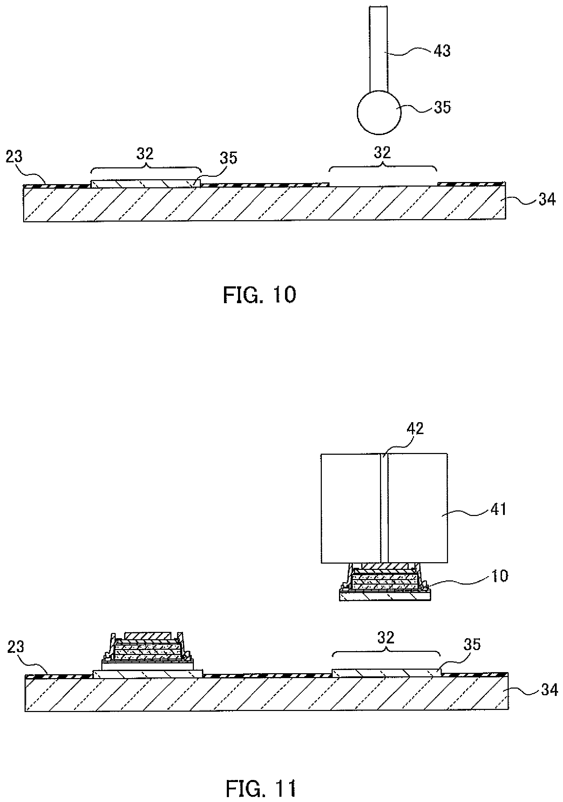

As illustrated in FIG. 10, glass plate 34 is provided. Glass plate 34 is a plane glass or a plane tempered glass having a thickness of 2 to 10 mm. Glass plate 34 may be a glass plate which is used in a typical solar cell.

As illustrated in FIG. 10, liquid repellent layer 23 is provided in a predetermined region of a back side of glass plate 34. The predetermined region is a region other than the region where the transparent electrodes of a plurality of (two or more) solar cell units 10 will be bonded (which is also referred to as "focal point 32"). Liquid repellent treatment is performed through chemical modification using a silane coupling agent having, for example, a fluorocarbon chain such as CF₃(CF₂)₇C₂H₄SiCl₃, or a hydrocarbon chain such as CH₃(CH₂)₁₇SiCl₃. Further, a liquid repellent layer of polytetrafluoroethylene (PTFE) may be formed to form liquid repellent layer 23.

As a result, regions where the transparent electrodes of the plurality of (two or more) solar cell units 10 are bonded are relatively lyophilic to a transparent adhesive. Further, it is also possible to apply lyophilic treatment to the regions where the transparent electrodes will be bonded (focal point 32) to improve wettability of the transparent adhesive.

### (3-2) Application of Transparent Adhesive

As illustrated in FIG. 10, transparent adhesive 35 is applied to focal point 32 having lyophilic property. For example, transparent adhesive 35 is applied using a dispenser with a screw type nozzle. Even if the viscosity of the transparent adhesive changes, a fixed amount of transparent adhesive is applied. While the dispensed amount of the adhesive differs according to an element size, in the present embodiment, 100 to 1,000 nanoliter of the transparent adhesive is applied using resin application head 43. The transparent adhesive wets and spreads focal point 32 while not being applied to liquid repellent layer 23.

### (4) Step of Bonding Solar Cell Unit to Glass Plate

As illustrated in FIG. 11, transparent electrode 12 of solar cell unit 10 is bonded to focal point 32 of glass plate 34 to which transparent adhesive 35 has been applied, while the position of transparent electrode 12 is adjusted to the position of focal point 32.

Solar cell unit 10 is thin and has a thickness of 5 to 50 µm, and includes a compound semiconductor such as GaAs and Ge. Therefore, solar cell unit 10 is extremely fragile. It is therefore necessary to bond solar cell unit 10 to glass plate 34 so as not to put a load on solar cell unit 10. Solar cell unit 10 is sucked by vacuum over suction hole 42 of mount head 41 having a planar shape and mounted on focal point 32. Amount load is set at about 10 to 50 gf (9.81 × 10⁻² to 4.90 × 10⁻¹ N).

The position of solar cell unit 10 mounted on focal point 32 is adjusted to the position of the lyophilic region (that is, a focal point) by solar cell unit 10 getting wet with transparent adhesive 35. As one example, if a surface of the transparent electrode of solar cell unit 10 is a square of 800 µm × 800 µm, focal point 32 is set to be a square of 900 µm × 900 µm, and the other region is set as a liquid repellent region. By this means, the position of solar cell unit 10 is adjusted on a glass surface by balance of surface tension of transparent adhesive 35, and solar cell unit 10 is disposed within focal point 32.

Solar cell units 10 may be mounted one by one using mount head 41 having a planar shape, or a plurality of solar cell units 10 can be collectively mounted on focal points by disposing a metal mask having through holes corresponding to a plurality of focal points on a glass plate. Further, it is also possible to dispose solar cell units 10 to the focal points by applying a liquid in which solar cell units 10 are dispersed to glass plate 34.

After solar cell units 10 are disposed on the focal points, transparent adhesive 35 cures. As transparent adhesive 35, for example, a two-liquid mixing type room temperature curable resin is used. When the room temperature curable resin is used, for example, if the resin is left at room temperature, the resin starts curing after about 90 minutes and completely cures 24 hours later. Transparent adhesive 35 may be an ultraviolet curable resin. When the ultraviolet curable resin is used, an ultraviolet ray is radiated after the positions of solar cell units 10 are adjusted to the focal points and solar cell units 10 are mounted on the focal points. In this manner, transparent electrodes 12 of solar cell units 10 are appropriately fixed at the focal points of glass plate 34.

### Removal of Water Repellent Layer

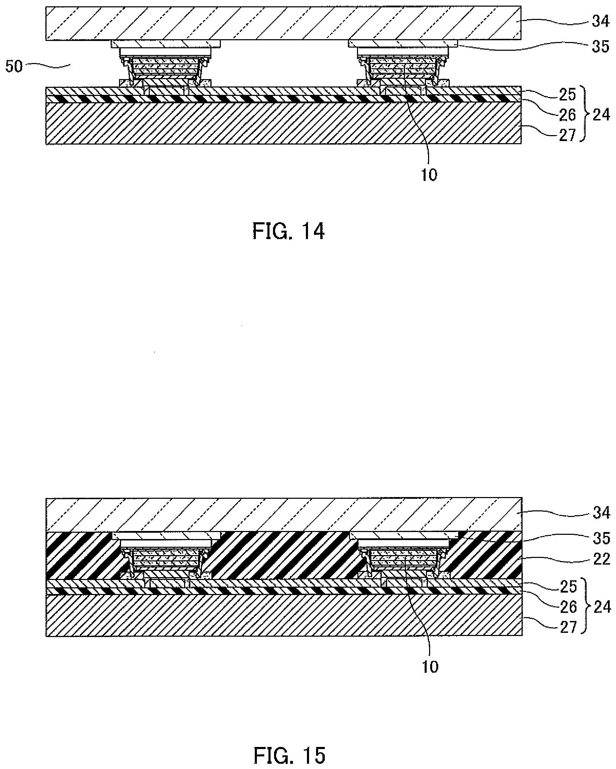

After solar cell units 10 are bonded, water repellent layer 23 on glass plate 34 is removed. The water repellent layer can be removed using, for example, a dry edge. Use of the dry edge makes the surface of glass plate 34 lyophilic. If water repellent layer 23 remains on glass plate 34 to which solar cell units 10 are bonded, wettability with sealing resin 22 (see FIG. 15) is degraded, which causes a peeling failure between glass plate 34 and sealing resin 22 due to a stress by a heat cycle. It is therefore preferable to remove water repellent layer 23 on glass plate 34.

### (5) Step of Attaching Solar Cell Unit to Substrate

Multi-junction solar cell units 10 bonded to glass plate 34 are attached to substrate 24. Specifically, lower electrode 9a is electrically connected to first conductive line 25a, and side electrode 16a is electrically connected to second conductive line 25b, thereby multi-junction solar cell units 10 bonded to glass plate 34 being attached to substrate 24. The position where multi-junction solar cell unit 10 bonded to glass plate 34 is attached to substrate 24 can be confirmed by, for example, an image of a bonding position photographed by a camera.

### (5-1) Disposition of Anisotropic Conductive Material (ACF) on Substrate

Multi-junction solar cell units 10 are preferably attached to substrate 24 using an anisotropic conductive material. Anisotropic conductive material 36 is disposed on substrate 24. Then, lower electrode 9a is connected to first conductive line 25a and side electrode 16a is connected to second conductive line 25b via anisotropic conductive material 36. Use of the anisotropic conductive material enables easy attachment of multi-junction solar cell unit 10 to substrate 24.

Anisotropic conductive material 36 can be a film-like or a paste-like material. Anisotropic conductive material 36 includes an epoxy resin and conductive particles which are dispersed in the epoxy resin. Anisotropic conductive material 36 is mainly used for, for example, implementing a driver for driving a liquid crystal display.

Preferably, film-like anisotropic conductive material 36 has a region larger than a region where solar cell unit 10 is disposed in substrate 24, and has, for example, a size which is sufficient to enclose the second conductive line. It is necessary for anisotropic conductive material 36 to have a thickness sufficiently larger than a gap between electrodes of solar cell units 10 and conductive lines on substrate 24. That is, a film of anisotropic conductive material 36 has a thickness larger than the thickness of first conductive line 25a and the thickness of second conductive line 25b. For example, when each thickness of first conductive line 25a and second conductive line 25b is 35 µm, the thickness of anisotropic conductive material 36 may be 40 to 60 µm.

First, first conductive line 25a and second conductive line 25b of substrate 24 are covered with the anisotropic conductive film. Then, multi-junction solar cell unit 10 bonded to glass plate 34 is thermally pressure-bonded to substrate 24 on which the anisotropic conductive film is disposed for attachment. It is also possible to temporarily fix the anisotropic conductive film on the substrate by applying heat and pressure which are sufficient for the anisotropic conductive film to partly cure, when the conductive lines are covered with the anisotropic conductive film. More specifically, as illustrated in FIG. 12, the film of anisotropic conductive material 36 is pasted on substrate 24. The film of anisotropic conductive material 36 is preferably pasted by applying heat and pressure to the whole of anisotropic conductive material 36 for 5 seconds or less using a plane tool which is heated at 60 to 100°C from above. At this time, it is preferable to paste anisotropic conductive material 36 to a deposition region under the conditions that an epoxy resin inside anisotropic conductive material 36 does not cause a curing reaction.

### Temporary Attachment of Solar Cell Unit to Substrate

As illustrated in FIG. 12, a temporary pressure-bonded article is obtained by adjusting the positions of a plurality of (two or more) solar cell units 10 bonded to glass plate 34 to substrate 24 to which anisotropic conductive material 36 is pasted and mounting the plurality of solar cell units 10 to substrate 24. A fiducial mark marked on glass plate 34 and a fiducial mark on substrate 24 are recognized by a CCD camera, and solar cell units 10 are disposed at predetermined positions of substrate 24 using information of the positions of the fiducial marks. Solar cell units 10 are temporarily pressure-bonded at room temperature and under low load. Therefore, there is no electrical conduction between the electrodes of solar cell units 10 and the conductive lines of substrate 24.

### Actual Attachment of Solar Cell Unit to Substrate

Next, as illustrated in FIG. 13, solar cell units 10 are electrically connected to substrate 24, and solar cell units 10 are fixed to substrate 24. Specifically, first, the temporal pressure-bonded article obtained by the temporal pressure-bonding step described above is placed on a metal stage so that substrate 24 is placed downside. Then, film-like protective sheet 39 formed of a polytetrafluoroethylene or polyimide material is disposed from above glass plate 34. Subsequently, pressure is applied to the temporal pressure-bonded article via protective sheet 39 using metal heating and pressurizing head 40 which is heated at approximately 180 to 220°C. A load per one solar cell unit is set at about 50 to 200 gf (0.49 to 1.96 N), and a pressurizing time is set at 5 to 20 seconds.

By this pressurization, the epoxy resin inside anisotropic conductive material 36 melts, and then cures. As a result, central electrode 16b of solar cell unit 10 is electrically connected to first conductive line 25a of the substrate, and side electrode 16a of solar cell unit 10 is electrically connected to second conductive line 25b of substrate 24. The electrical connection is achieved via the conductive particles within anisotropic conductive material 36. In this manner, solar cell unit 10 is electrically connected to first conductive line 25a and second conductive line 25b, and solar cell unit 10 is physically fixed at the substrate.

FIG. 14 illustrates a structure of the solar cell unit after the actual pressure-bonding step. Variation in the thickness of glass plate 34 is small and 10 µm or less. Variation in the thickness of substrate 24 is also small. It is therefore possible to attach a plurality of solar cell units 10 having a thickness of 10 µm or less to substrate 24 collectively and stably.

### Reinforcement Using Sealing Resin

As illustrated in FIG. 15, gap 50 between substrate 24 and glass plate 34 in the structure illustrated in FIG. 14 is sealed with sealing resin 22. By sealing gap 50 with sealing resin 22, strength of a package is maintained, and chemical resistance is improved. Sealing resin 22 is generally an epoxy resin or a silicone resin. Examples of sealing resin 22 include two-liquid adhesives each including a base compound and a curing agent, resin materials which cure by irradiation with ultraviolet rays, and resin materials which cure by heating.

If solar cell unit 10 is fixed at substrate 24 only with anisotropic conductive material 36, stress is concentrated on a portion connected with anisotropic conductive material 36 due to a difference between a linear expansion coefficient of glass plate 34 and a linear expansion coefficient of substrate 24. Sealing resin 22 filling gap 50 between substrate 24 and glass plate 34 can reduce this concentration of the stress. When gap 50 is filled with sealing resin 22, substrate 24 and glass plate 34 which are fixed via solar cell unit 10 are integrated.

Gap 50 between substrate 24 and glass plate 34 is filled with sealing resin 22 generally using a method in which substrate 24 is placed on the metal stage heated at 50 to 80°C and liquid sealing resin 22 is poured into gap 50 using capillary action. After gap between GaAs substrate 1 and substrate 24 is filled with sealing resin 22, sealing resin 22 is heated at about 150 to 200°C for 15 minutes to one hour so that sealing resin 22 cures.

It is also possible to use an alternative method in which sealing resin 22 is applied to substrate 24 before the temporary pressure-bonding step, gap 50 is filled with sealing resin 22 by pressure being applied during application of heat and pressure in the actual pressure-bonding step, and sealing resin 22 is made to cure by being heated in the actual pressure-bonding step. According to this method, it is possible to perform electrical connection between solar cell unit 10 and first conductive line 25a and second conductive line 25b, and sealing of the gap with sealing resin 22 at the same time.

After gap 50 between substrate 24 and glass plate 34 is filled with sealing resin 22, sealing resin 22 is heated at a temperature of 80°C or lower (for example, room temperature (20±15°C)) to naturally cure. Alternatively, sealing resin 22 is made to cure by being irradiated with ultraviolet rays.

### (6) Step of Providing Condenser Lens

A sheet-like condenser lens having a plurality of focal points is provided. The condenser lens is a fly-eye lens having a plurality of focal points on a surface on an opposite side of a light incidence surface.

### (7) Step of Bonding Condenser Lens to Glass Plate

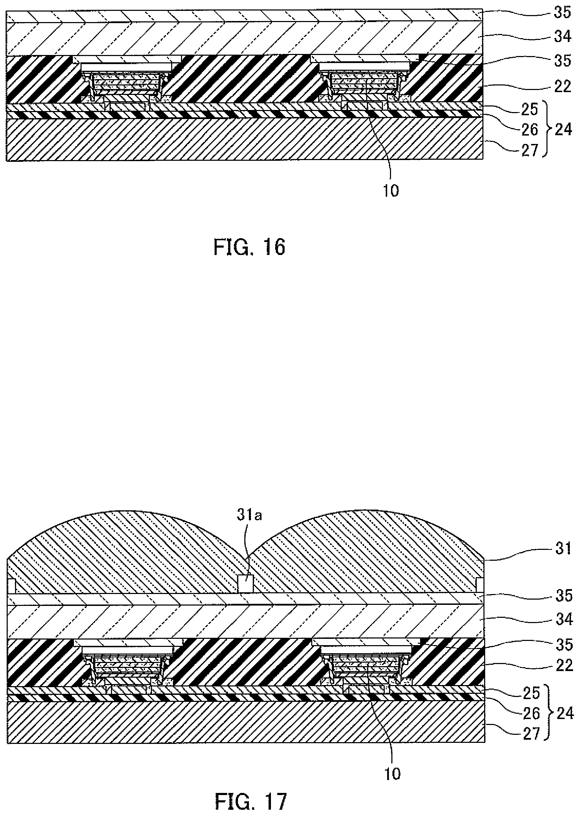

As illustrated in FIG. 16, transparent adhesive 35 is applied to glass plate 34. Transparent adhesive 35 can be applied using a dispensing method, a printing method, a spin coating method, or the like. Transparent adhesive 35 may be the same as an adhesive for bonding solar cell unit 10 to glass plate 34.

As illustrated in FIG. 17, lens 31 is pasted to glass plate 34 using transparent adhesive 35 and fixed. According to the present invention a recess 31a is provided at a part of a boundary region with the transparent adhesive, of lens 31. Recess 31a is provided in a region other than a light transmitting portion. Recess 31a traps air bubbles included in the transparent adhesive and prevents the air bubbles from flowing into the light transmitting portion of lens 31. In this manner, it is possible to limit a reduction in efficiency as a solar cell due to reflection of light transmitted through lens 31 by the air bubbles.

As described above, the method for manufacturing a solar cell according to this embodiment includes a step of pasting a plurality of solar cell units 10 to one surface of glass plate 34 and pasting lens 31 which is a fly-eye lens to the other surface of glass plate 34. The focal points of the fly-eye lens are respectively set at solar cell units 10, and are set at transparent electrodes 12.

### <State Where Solar Cell is Placed>

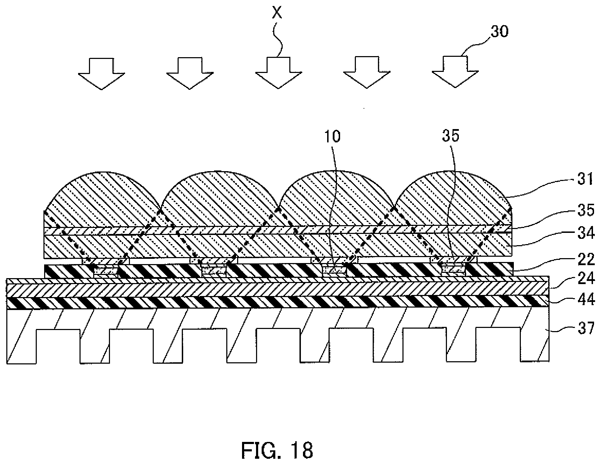

FIG. 18 shows a simplified drawing of a solar cell according to the embodiment including a plurality of solar cell units 10 pasted to one surface of a glass plate, and fly-eye lens 31 pasted to the other surface of the glass plate. Heat dissipating member 37 is disposed at a lower surface of substrate 24 of the solar cell via heat dissipation resin 44.

When the solar cell of FIG. 18 is disposed under insolation, sunlight 30 is radiated to lens 31 along an arrow direction. The sunlight incident on lens 31 preferably transmits through transparent adhesive 35 and glass plate 34, and is concentrated at transparent electrode 12, and is incident on cell stack 50. The light which has been transmitted through transparent electrode 12 transmits through top cell layer T, middle cell layer M and bottom cell layer B in the cell stack. The light corresponding to an absorption wavelength of each cell layer in the sunlight is converted into an electromotive force. For example, conversion efficiency in solar cell unit 10 is about 30 to 50%.

Typically, there is a risk that lens 31 might be heated by infrared rays included in the sunlight. However, in the solar cell according to the embodiment, heat of lens 31 is quickly transmitted to substrate 24 through glass plate 34, transparent electrode 12, upper electrode 9b and side electrode 16a, and dissipated outside from substrate 24. Therefore, lens 31 is less likely to be heated.

Further, in the solar cell according to the embodiment, glass plate 34 and lens 31 are in close contact with solar cell unit 10. Still further, solar cell unit 10 has side electrode 16a. Therefore, heat of lens 31 can be transmitted to substrate 24 through side electrode 16a. Since base 27 of substrate 24 has a large surface area and thus heat transmitted to substrate 24 is dissipated outside from base 27, heat of lens 31 is easily dissipated. It is therefore possible to mold lens 31 with a transparent resin having low heat resistance.

Accordingly, with lens 31 formed of a transparent resin, it is possible to reduce a cost of the material of lens 31 compared to a case where lens 31 is formed of glass. Further, with lens 31 formed of a transparent resin, it is possible to reduce weight of a solar cell compared to a case where lens 31 is formed of glass. By this means, it is possible to improve, for example, workability for setting the solar cell under insolation.

Further, typically, although a stress may be caused within the solar cell by heat from lens 31, the stress caused in the solar cell according to this embodiment is dispersed by sealing resin 22 filling the gap between substrate 24 and lens 31. It is therefore possible to suppress breakage of the cell stack and solar cell unit 10 due to concentration of the stress on transparent adhesive 35 or anisotropic conductive material 36.

Since the solar cell according to the embodiment has a solar cell unit which includes a transparent electrode disposed on a light receiving surface, the solar cell unit can efficiently receive sunlight. Further, the solar cell according to the embodiment includes solar cell unit 10 having a cell stack with a laminated structure including three layers of top cell layer T, middle cell layer M and bottom cell layer B. Therefore, it is possible to effectively perform photoelectric conversion of light with various wavelength regions included in the sunlight, so that it is possible to realize a high-efficient solar cell.

Further, in the solar cell according to the embodiment, since glass plate 34 and lens 31 is in close contact with solar cell unit 10, the thickness of the solar cell (a distance from a bottom surface of substrate 24 to the top of lens 31) can be designed to be about 20 mm. The thickness of the solar cell according to the embodiment can be set to be approximately 10% of the thickness of a conventional solar cell in which lens 31 is disposed away from solar cell unit 10.

The solar cell according to the embodiment includes solar cell unit 10 in which an electrode having a potential of top cell layer T and an electrode having a potential of bottom cell layer B are both disposed at a side opposite to a sunlight incidence surface. Since solar cell unit 10 can be attached to substrate 24 with one step, it is possible to shorten a production lead time of the solar cell.

On the other hand, a solar cell unit in a conventional multi-junction compound solar cell has a double-sided electrode structure having a surface electrode and a backside electrode. Therefore, there is often a case where the backside electrode is attached using a die bonding method, while the surface electrode is attached using a wire bonding method. That is, in the conventional solar cell, in order to realize electrical connection to the outside, it requires two attachment steps for attaching the backside electrode and attaching the surface electrode. As a result, the production lead time becomes long.

As described above, in this embodiment, it is possible to easily manufacture a solar cell which has high resistance to temperature cycle, high moisture resistance and high impact resistance, and which is light, thin, short and small. Further, since an electrode at a sunlight receiving side is electrically connected to second conductive line 25b on substrate 24 which has heat dissipation properties, through a side potion of solar cell unit 10, it is possible to utilize an electric conducting path as a heat conducting path, so that it is possible to realize high heat dissipation of the solar cell.

### Industrial Applicability

The solar cell of the present invention is suitable for use in various situations including power generation use in space and use as concentrating solar cell on earth. Further, it is possible to dramatically improve conversion efficiency of sunlight compared to conventional silicon solar cell. Therefore, the solar cell of the present invention can be used as a large-scale power generation system in an area with a large amount of solar radiation.

### Reference Signs List

1 GaAs Substrate
2a Upper contact layer
2b Lower contact layer
4 Sacrificial layer
4a Sacrificial layer recess
9a Lower electrode
9b Upper electrode
10, 120, 220 Solar cell unit
12 Transparent electrode
15 Surface electrode
16a Side electrode
16b Central electrode
16c Au/Ti laminated film
16d Ti film
17 Second insulating layer
17a, 17b Window of second insulating layer
18 Resist
19a, 19b Tunnel layer
20 Grid layer
21 Buffer layer
22 Sealing resin
23 Water repellent layer
24 Substrate
25a First conductive line
25b Second conductive line
26 First insulating layer
27 Base (metal plate)
28 Wax
29 Holding plate
30 Sunlight
31 Lens
32 Focal point
34 Glass plate
35 Transparent adhesive
36 Anisotropic conductive material
37 Heat dissipating member
38 Stage
39 Protective sheet
40 Heating and pressurizing head
41 Mount head
42 Absorption hole
43 Resin application head
44 Heat dissipation resin
50 Cell stack
100, 200 Solar cell
110 Optical component
113 Recess
124A First connection portion
124B Second connection portion
140 Back sheet
150 Circuit board
153 Insulator
154 Conductor
154A, 154B Electrode portion
155 Adhesion layer
210 Optical component
230 Primary mirror
231, 234 Metal film
237 Gap
239 Aperture
300 Solid transparent optical panel
400C Concentrating light energy collecting unit
420 Socket connector
A Line enclosing periphery of solar cell unit 10 in solar cell in FIG. 1
B Bottom cell layer
M Middle cell layer
T Top cell layer

## Claims

1. A solar cell comprising:
a substrate (24) comprising a plate-like base (27) having heat dissipation properties, and a first conductive line (25a) and a second conductive line (25b)disposed and electrically isolated from each other on the base (27);
a plurality of multi-junction solar cell units (10) each having a lower electrode (9a) that is bonded on, and electrically connected to, the first conductive line (25a), a cell stack (50) comprising a bottom cell layer (B) disposed on an upper surface of the lower electrode (9a) and a top cell layer (T) disposed on an upper surface of the bottom cell layer (B), a transparent electrode (12) disposed on an upper surface of the top cell layer (T), and a conductor (154) connecting the transparent electrode (12) to the second conductive line (25b);
a single glass plate (34) having one face bonded to the transparent electrodes (12) of the plurality of multi-junction solar cell units (10) via an adhesive (35); and a condenser lens (31),
**characterized in that** the condenser lens (31) is disposed on another face of the glass plate (34) via a transparent adhesive, the another face being flat,
wherein the condenser lens (31) is a single fly-eye lens having a plurality of plano-convex lenses, each having a curved light receiving surface, a focal point (32) at the respective transparent electrode (12) of the plurality of multijunction solar cell units (10), and a recess (31a) for trapping air bubbles in the transparent adhesive provided at a part of a boundary region with the transparent adhesive other than regions where light is transmitted to the respective solar cell of the plurality of multijunction solar cell units (10).

2. The solar cell according to claim 1, further comprising an anisotropic conductive material disposed between the substrate (24) and each of the plurality of multi-junction solar cell units (10).

3. The solar cell according to claim 1, wherein:
the substrate is a single substrate.

4. The solar cell according to claim 1, wherein each of the multi-junction solar cell units (10) further comprises:
an insulating layer (17) disposed on a side surface of the cell stack (50),
wherein the conductor (154) is a side electrode disposed on the side surface of the cell stack (50) via the insulating layer (17).

5. The solar cell according to claim 4, wherein a lower surface of the side electrode (16a) is disposed below a lower surface of the lower electrode (9a).

6. The solar cell according to claim 4, wherein each of the plurality of multi-junction solar cell units (10) further comprises a central electrode (16b) at a side of the lower surface of the lower electrode (9a), and the lower surface of the side electrode (16a) and a lower surface of the central electrode (16b) are disposed on the same plane.

7. A method for manufacturing a solar cell, comprising:
providing a substrate comprising a plate-like base (27) having heat dissipation properties, and a first conductive line (25a) and a second conductive line (25b) disposed and electrically isolated from each other on the base;
providing a plurality of multi-junction solar cell units (10) each comprising a lower electrode (9a), a cell stack (50) comprising a bottom cell layer (B) disposed on an upper surface of the lower electrode (9a) and a top cell layer (T) disposed on an upper surface of the bottom cell layer (B), a transparent electrode (12) disposed on an upper surface of the top cell layer (T), and a conductor (154) connecting the transparent electrode (12) to the second conductive line (25b);
providing a single glass plate (34);
bonding upper surfaces of the transparent electrodes (12) of the plurality of solar cell units (10) to one face of the glass plate (34) to fix the plurality of multi-junction solar cell units (10) to the glass plate (34);
attaching the plurality of multi-junction solar cell units (10) to the substrate (24) so that in each multi-junction solar cell unit, the lower electrode (9a) is electrically connected to the first conductive line (25a) and the conductor (154) is electrically connected to the second conductive line (25b);
providing a sheet-like condenser lens having a plurality of focal points; and
bonding the condenser lens (31), **characterized by** the following steps:
the condenser lens (31) is bonded to another face of the glass plate (34), the another face being flat,
wherein the condenser lens (31) is a single fly-eye lens having a plurality of plano-convex lenses, each having a curved light receiving surface, a focal point (32) at the respective transparent electrode (12) of the plurality of multijunction solar cell units (10), and a recess (31a) for trapping air bubbles in the transparent adhesive provided at a part of a boundary region with the transparent adhesive other than regions where light is transmitted to the respective solar cell of the plurality of multijunction solar cell units (10).

8. The method for manufacturing the solar cell according to claim 7, wherein in attaching the multi-junction solar cell units (10) to the substrate (24), an anisotropic conductive material is disposed on the substrate (24) for each of the multi-junction solar cell units (10), and electrical connection between the first conductive line (25a) and the lower electrode (9a) and electrical connection between the second conductive line (25b) and the conductor (154) are accomplished via the anisotropic conductive material.

9. The method for manufacturing the solar cell according to claim 7, wherein each of the multi-junction solar cell units (10) further comprises:
an insulating layer (17) disposed on a side surface of the cell stack (50),
wherein the conductor (154) is a side electrode disposed on the side surface of the cell stack (50) via the insulating layer (17).

10. The method for manufacturing the solar cell according to claim 9, wherein in the solar cell units, a lower surface of the side electrode (16a) is disposed below a lower surface of the lower electrode (9a).

11. The method for manufacturing the solar cell according to claim 9, wherein;
each of the solar cell units (10) further comprises a central electrode (16b)at a side of the lower surface of the lower electrode (9a); and
the lower surface of the side electrode (16a) and a lower surface of the central electrode (16b) are disposed on the same plane.

## Patentansprüche

1. Solarzelle, umfassend:
ein Substrat (24), umfassend eine plattenartige Basis (27) mit Wärmeableitungseigenschaften und eine erste Leitbahn (25a) und eine zweite Leitbahn (25b), die auf der Basis (27) angeordnet und elektrisch voneinander isoliert sind;
eine Vielzahl von Mehrfachsolarzelleinheiten (10), von denen jede eine untere Elektrode (9a), die an die erste Leitbahn (25a) gebondet und mit ihr elektrisch verbunden ist, einen Zellstapel (50), umfassend eine Bodenzellschicht (B), die an einer unteren Fläche der unteren Elektrode (9a) angeordnet ist, und eine obere Zellschicht (T), die an einer oberen Fläche der Bodenzellschicht (B) angeordnet ist, eine durchsichtige Elektrode (12), die an einer oberen Fläche der oberen Zellschicht (T) angeordnet ist, und einen Leiter (154), der die durchsichtige Elektrode (12) mit der zweiten Leitbahn (25b) verbindet, umfasst;
eine einzelne Glasplatte (34) mit einer Seite, die an die transparenten Elektroden (12) der Vielzahl von Mehrfachsolarzelleinheiten (10) über einen Klebstoff (35) gebondet ist; und eine Kondensorlinse (31),
**dadurch gekennzeichnet, dass** die Kondensorlinse (31) über einen transparenten Klebstoff an einer anderen Seite der Glasplatte (34) angeordnet ist, wobei die andere Seite flach ist,
wobei die Kondensorlinse (31) eine einzelne facettenartige Linse mit einer Vielzahl von plankonvexen Linsen ist, von denen jede eine gekrümmte lichtempfangende Fläche, einen Brennpunkt (32) an der jeweiligen durchsichtigen Elektrode (12) der Vielzahl von Mehrfachsolarzelleinheiten (10) und eine Vertiefung (31a) zum Auffangen von Luftblasen in dem transparenten Klebstoff hat, die an einem Teil einer Grenzregion mit dem durchsichtigen Klebstoff bereitgestellt ist, die von Regionen, wo Licht an die jeweilige Solarzelle der Vielzahl von Mehrfachsolarzelleinheiten (10) abgegeben wird, verschieden ist.

2. Solarzelle nach Anspruch 1, ferner umfassend ein anisotropes leitendes Material, das zwischen dem Substrat (24) und jeder der Vielzahl von Mehrfachsolarzelleinheiten (10) angeordnet ist.

3. Solarzelle nach Anspruch 1, wobei:
das Substrat ein einzelnes Substrat ist.

4. Solarzelle nach Anspruch 1, wobei jede der Mehrfachsolarzelleinheiten (10) ferner Folgendes umfasst:
eine Isolationsschicht (17), die an einer Seitenfläche des Zellstapels (50) angeordnet ist,
wobei der Leiter (154) eine Seitenelektrode ist, die über die Isolationsschicht (17) an der Seitenfläche des Zellstapels (50) angeordnet ist.

5. Solarzelle nach Anspruch 4, wobei eine untere Fläche der Seitenelektrode (16a) unter einer unteren Fläche der unteren Elektrode (9a) angeordnet ist.

6. Solarzelle nach Anspruch 4, wobei jede der Vielzahl von Mehrfachsolarzelleinheiten (10) ferner eine zentrale Elektrode (16b) an einer Seite der unteren Fläche der unteren Elektrode (9a) umfasst und die untere Fläche der Seitenelektrode (16a) und eine untere Fläche der zentralen Elektrode (16b) auf der gleichen Ebene angeordnet sind.

7. Verfahren zum Herstellen einer Solarzelle, umfassend:
Bereitstellen eines Substrats, umfassend eine plattenartige Basis (27) mit Wärmeableitungseigenschaften und eine erste Leitbahn (25a) und eine zweite Leitbahn (25b), die auf der Basis angeordnet und elektrisch voneinander isoliert sind;
Bereitstellen einer Vielzahl von Mehrfachsolarzelleinheiten (10), von denen jede eine untere Elektrode (9a), einen Zellstapel (50), umfassend eine Bodenzellschicht (B), die an einer unteren Fläche der unteren Elektrode (9a) angeordnet ist, und eine obere Zellschicht (T), die an einer oberen Fläche der Bodenzellschicht (B) angeordnet ist, eine durchsichtige Elektrode (12), die an einer oberen Fläche der oberen Zellschicht (T) angeordnet ist, und einen Leiter (154), der die durchsichtige Elektrode (12) mit der zweiten Leitbahn (25b) verbindet, umfasst;
Bereitstellen einer einzelnen Glasplatte (34);
Bonden von Oberflächen der durchsichtigen Elektroden (12) der Vielzahl von Solarzelleinheiten (10) an eine Seite der Glasplatte (34), um die Vielzahl von Mehrfachsolarzelleinheiten (10) an der Glasplatte (34) zu befestigen;
Befestigen der Vielzahl von Mehrfachsolarzelleinheiten (10) an dem Substrat (24), sodass in jeder Mehrfachsolarzelleinheit die untere Elektrode (9a) elektrisch mit der ersten Leitbahn (25a) verbunden ist und der Leiter (154) elektrisch mit der zweiten Leitbahn (25b) verbunden ist;
Bereitstellen einer blattartigen Kondensorlinse mit einer Vielzahl von Brennpunkten; und
Bonden der Kondensorlinse (31), **gekennzeichnet durch** die folgenden Schritte:
die Kondensorlinse (31) wird an eine andere Seite der Glasplatte (34) gebondet, wobei die andere Seite flach ist,
wobei die Kondensorlinse (31) eine einzelne facettenartige Linse mit einer Vielzahl von plankonvexen Linsen ist, von denen jede eine gekrümmte lichtempfangende Fläche, einen Brennpunkt (32) an der jeweiligen durchsichtigen Elektrode (12) der Vielzahl von Mehrfachsolarzelleinheiten (10) und eine Vertiefung (31a) zum Auffangen von Luftblasen in dem transparenten Klebstoff hat, die an einem Teil einer Grenzregion mit dem durchsichtigen Klebstoff bereitgestellt ist, die von Regionen, wo Licht an die jeweilige Solarzelle der Vielzahl von Mehrfachsolarzelleinheiten (10) abgegeben wird, verschieden ist.

8. Verfahren zum Herstellen der Solarzelle nach Anspruch 7, wobei beim Befestigen der Mehrfachsolarzelleinheiten (10) an dem Substrat (24) für jede der Mehrfachsolarzelleinheiten (10) ein anisotropes leitendes Material an dem Substrat (24) angeordnet wird und eine elektrische Verbindung zwischen der ersten Leitbahn (25a) und der unteren Elektrode (9a) und eine elektrische Verbindung zwischen der zweiten Leitbahn (25b) und dem Leiter (154) über das anisotrope leitende Material erreicht werden.

9. Verfahren zum Herstellen der Solarzelle nach Anspruch 7, wobei jede der Mehrfachsolarzelleinheiten (10) ferner Folgendes umfasst:
eine Isolationsschicht (17), die an einer Seitenfläche des Zellstapels (50) angeordnet ist,
wobei der Leiter (154) eine Seitenelektrode ist, die über die Isolationsschicht (17) an der Seitenfläche des Zellstapels (50) angeordnet ist.

10. Verfahren zum Herstellen der Solarzelle nach Anspruch 9, wobei in den Solarzelleinheiten eine untere Fläche der Seitenelektrode (16a) unter einer unteren Fläche der unteren Elektrode (9a) angeordnet ist.

11. Verfahren zum Herstellen der Solarzelle nach Anspruch 9, wobei:
jede der Solarzelleinheiten (10) ferner eine zentrale Elektrode (16b) an einer Seite der unteren Fläche der unteren Elektrode (9a) umfasst; und
die untere Fläche der Seitenelektrode (16a) und eine untere Fläche der zentralen Elektrode (16b) auf der gleichen Ebene angeordnet sind.

## Revendications

1. Cellule solaire comprenant :
un substrat (24) comprenant une base de type plaque (27) présentant des propriétés de dissipation thermique et une première ligne conductrice (25a) et une deuxième ligne conductrice (25b) disposées sur la base (27) et électriquement isolées l'une de l'autre ;
une pluralité d'unités de cellules solaires multi-jonctions (10), chacune présentant une électrode inférieure (9a) qui est liée à la première ligne conductrice (25a) et électriquement connectée à celle-ci, un empilement de cellules (50) comprenant une couche de cellules inférieures (B) disposée sur une surface supérieure de l'électrode inférieure (9a) et une couche cellulaire supérieure (T) disposée sur une surface supérieure de la couche cellulaire inférieure (B), une électrode transparente (12) disposée sur une surface supérieure de la couche cellulaire supérieure (T) et un conducteur (154) connectant l'électrode transparente (12) à la deuxième ligne conductrice (25b) ;
une plaque vitrée unique (34) présentant une face liée aux électrodes transparentes (12) de la pluralité d'unités de cellules solaires multi-jonctions (10) par le biais d'un adhésif (35) ; et une lentille de condenseur (31),
**caractérisée en ce que** la lentille de condenseur (31) est disposée sur une autre face de la plaque vitrée (34) par le biais d'un adhésif transparent, ladite autre face étant plate,
la lentille de condenseur (31) étant une lentille unique en oeil de mouche présentant une pluralité de lentilles plan-convexe, chacune présentant une surface de réception de lumière incurvée, un point focal (32) au niveau de l'électrode transparente respective (12) de la pluralité d'unités de cellules solaires multi-jonctions (10) et un évidement (31a) destiné à piéger des bulles d'air dans l'adhésif transparent disposé dans une partie d'une région limite avec l'adhésif transparent autre que des régions où la lumière est transmise à la cellule solaire respective de la pluralité d'unités de cellules solaires multi-jonctions (10).

2. Cellule solaire selon la revendication 1, comprenant en outre un matériau conducteur anisotrope disposé entre le substrat (24) et chacune de la pluralité d'unités de cellules solaires multi-jonctions (10).

3. Cellule solaire selon la revendication 1, dans laquelle :
le substrat est un substrat unique.

4. Cellule solaire selon la revendication 1, dans laquelle chacune des unités de cellules solaires multi-jonctions (10) comprend en outre :
une couche isolante (17) disposée sur une surface latérale de l'empilement de cellules (50),
le conducteur (154) étant une électrode latérale disposée sur la surface latérale de l'empilement de cellules (50) par le biais de la couche isolante (17).

5. Cellule solaire selon la revendication 4, dans laquelle une surface inférieure de l'électrode latérale (16a) est disposée sous une surface inférieure de l'électrode inférieure (9a).

6. Cellule solaire selon la revendication 4, dans laquelle chacune de la pluralité d'unités de cellules solaires multi-jonctions (10) comprend en outre une électrode centrale (16b) sur un côté de la surface inférieure de l'électrode inférieure (9a), et la surface inférieure de l'électrode latérale (16a) et une surface inférieure de l'électrode centrale (16b) sont disposées sur le même plan.

7. Procédé de fabrication d'une cellule solaire, comprenant :
la fourniture d'un substrat comprenant une base de type plaque (27) présentant des propriétés de dissipation thermique et une première ligne conductrice (25a) et une deuxième ligne conductrice (25b) disposées sur la base et isolées électriquement l'une de l'autre ;
la fourniture d'une pluralité d'unités de cellules solaires multi-jonctions (10), chacune comprenant une électrode inférieure (9a), un empilement de cellules (50) comprenant une couche de cellules inférieures (B) disposée sur une surface supérieure de l'électrode inférieure (9a) et une couche cellulaire supérieure (T) disposée sur une surface supérieure de la couche cellulaire inférieure (B), une électrode transparente (12) disposée sur une surface supérieure de la couche cellulaire supérieure (T) et un conducteur (154) connectant l'électrode transparente (12) à la deuxième ligne conductrice (25b) ;
la fourniture d'une plaque vitrée unique (34) ;
la liaison de surfaces supérieures des électrodes transparentes (12) de la pluralité d'unités de cellules solaires (10) à une face de la plaque vitrée (34) pour fixer la pluralité d'unités de cellules solaires multi-jonctions (10) à la plaque vitrée (34) ;
la fixation de la pluralité d'unités de cellules solaires multi-jonctions (10) au substrat (24) de manière que dans chaque unité de cellule solaire multi-jonction, l'électrode inférieure (9a) est électriquement connectée à la première ligne conductrice (25a) et le conducteur (154) est électriquement connecté à la deuxième ligne conductrice (25b) ;
la fourniture d'une lentille de condenseur en forme de feuille présentant une pluralité de points focaux ; et
la liaison de la lentille de condenseur (31), **caractérisé par** les étapes suivantes :
la lentille de condenseur (31) est liée à une autre face de la plaque vitrée (34), ladite autre face étant plate,
la lentille de condenseur (31) étant une lentille unique en oeil de mouche comportant une pluralité de lentilles plan-convexe, chacune présentant une surface de réception de lumière incurvée, un point focal (32) au niveau de l'électrode transparente respective (12) de la pluralité d'unités de cellules solaires multi-jonctions (10) et un évidement (31a) destiné à piéger des bulles d'air dans l'adhésif transparent disposé dans une partie d'une région limite avec l'adhésif transparent autre que des régions où la lumière est transmise à la cellule solaire respective de la pluralité d'unités de cellules solaires multi-jonctions (10).

8. Procédé de fabrication de la cellule solaire selon la revendication 7, dans lequel lors de la fixation des unités de cellules solaires multi-jonctions (10) au substrat (24), un matériau conducteur anisotrope est disposé sur le substrat (24) pour chacune des unités de cellules solaires multi-jonctions (10), et une connexion électrique entre la première ligne conductrice (25a) et l'électrode inférieure (9a) et une connexion électrique entre la deuxième ligne conductrice (25b) et le conducteur (154) sont réalisées par le biais du matériau conducteur anisotrope.

9. Procédé de fabrication de la cellule solaire selon la revendication 7, dans lequel chacune des unités de cellules solaires multi-jonctions (10) comprend en outre :
une couche isolante (17) disposée sur une surface latérale de l'empilement de cellules (50),
le conducteur (154) étant une électrode latérale disposée sur la surface latérale de l'empilement de cellules (50) par le biais de la couche isolante (17).

10. Procédé de fabrication de la cellule solaire selon la revendication 9, dans lequel dans les unités de cellules solaires, une surface inférieure de l'électrode latérale (16a) est disposée sous une surface inférieure de l'électrode inférieure (9a).

11. Procédé de fabrication de la cellule solaire selon la revendication 9, dans lequel :
chacune des unités de cellules solaires (10) comprend en outre une électrode centrale (16b) sur un côté de la surface inférieure de l'électrode inférieure (9a) ; et
la surface inférieure de l'électrode latérale (16a) et une surface inférieure de l'électrode centrale (16b) sont disposées sur le même plan.
